# EUROPÄISCHE PATENTSCHRIFT

(11) **EP 2 609 797 B1**
(45) Veröffentlichungstag und Bekanntmachung des Hinweises auf die Patenterteilung: **12.06.2019**
(21) Anmeldenummer: 11770385.0
(22) Anmeldetag: 23.08.2011
(51) Int. Cl.: H05K 5/00, B60T 8/36

(54) **GEHÄUSE ZUR AUFNAHME EINES ELEKTRONISCHEN SCHALTUNGSTRÄGERS**
HOUSING FOR ACCOMMODATING AN ELECTRONIC CIRCUIT CARRIER
BOÎTIER DESTINÉ À CONTENIR UN SUPPORT DE CIRCUIT ÉLECTRONIQUE

(30) Priorität: 25.08.2010 DE 102010039736
(43) Veröffentlichungstag der Anmeldung: 03.07.2013
(73) Patentinhaber: Robert Bosch GmbH, 70442 Stuttgart (DE)
(72) Erfinder: WEH, Andreas, 87477 Sulzberg (DE); GOLOB, Andreas, 73765 Neuhausen A.D.F. (DE); SCHMID-SCHOENBEIN, Christian, Changsha Hunan 410100 (CN); HUDITZ, Andreas, 87509 Immenstadt (DE); KAECHELE, Uwe, 72813 St. Johann-Wuertingen (DE)
(86) Internationale Anmeldenummer: PCT/EP2011/064416
(87) Internationale Veröffentlichungsnummer: WO 2012/025504

(56) Entgegenhaltungen:
- EP-A1- 0 792 094
- EP-A1- 1 895 823
- DE-A1-102007 038 538

## Beschreibung

Die vorliegende Erfindung betrifft ein Gehäuse zur Aufnahme eines elektronischen Schaltungsträgers nach dem Oberbegriff des Anspruchs 1, sowie ein Verfahren zur Montage eines Gehäuses zur Aufnahme eines elektronischen Schaltungsträgers.

### Stand der Technik

Aus dem Stand der Technik sind Gehäuse bekannt, in denen Schaltungsträger mit darauf kontaktierten elektrischen und/oder elektronischen Bauelementen angeordnet werden können, um die Schaltung vor Umwelteinflüssen zu schützen. Die in einem derartigen Gehäuse angeordneten elektronischen Schaltungsträger müssen in der Regel mit externen Geräten, beispielsweise einem Verbraucher, einer Energiequelle oder einem elektronischen Bauteil kontaktiert werden. Eine bevorzugte Kontaktierungsmethode ist die bekannte Einpresstechnik, bei der Kontaktleitungen direkt in metallisierte Kontaktöffnungen des Schaltungsträgers eingepresst werden, wobei die Kontaktöffnungen in elektrischem Kontakt zu den Leiterbahnen des Schaltungsträgers stehen. Die Enden der eingepressten Kontaktleitungen besitzen dabei einen Durchmesser, der geringfügig größer ist als der Durchmesser einer entsprechenden Kontaktöffnung im Schaltungsträger. Beim Einpressen der Kontaktleitung findet deshalb eine Verformung sowohl des Einpresskontakts als auch der Kontaktöffnung statt. Durch diese Kraftwirkung wird eine zuverlässige und gasdichte elektrische Verbindung hergestellt. Nachteilig beim Kontaktieren über Einpressen ist jedoch, dass eine große Kraft aufgewendet werden muss. Diese Kraft bewirkt, dass der Schaltungsträger im Bereich der eingepressten Kontaktleitungen während des Einpressens in Einpressrichtung ausgelenkt wird und sich verbiegt. Durch diese Verbiegung kann eine Beschädigung des Schaltungsträgers verursacht werden. Deswegen ist es üblich den Schaltungsträger während des Einpressvorgangs durch ein Werkzeug abzustützen. Diese Vorgehensweise ist jedoch nur möglich, wenn der Schaltungsträger in dem Gehäuse zugänglich ist, das Gehäuse also nicht verschlossen ist. Dadurch ergeben sich Nachteile im Produktionsablauf, da das Gehäuse erst nach dem Einpressvorgang verschlossen werden kann.

Aus der DE 10 2007 038538 A1 ist ein zweiteiliges Gehäuse mit einem darin angeordneten Schaltungsträger bekannt. Durch eine Öffnung des Gehäusedeckels werden Kontaktleitungen eines Anschlusssteckers in den Schaltungsträger eingesteckt. Als Abstützelemente für den Schaltungsträger sind Auflageflächen im Gehäuseboden vorgesehen, die im Bereich der Einsteckkontakte angeordnet sind und die Einpresskräfte aufnehmen.

Aus der EP 1 895 823 A1 ist eine Gehäusestruktur für eine Leiterplatte mit Einpresspins bekannt. Für den Randbereich und für die Bereiche der Leiterplatte zwischen den Einpresspins sind Stützstrukturen in einem Gehäuseteil vorgesehen.

### Offenbarung der Erfindung

Es wird ein Gehäuse zur Aufnahme eines elektronischen Schaltungsträgers vorgeschlagen. Der Schaltungsträger weist eine erste und eine gegenüberliegende zweite Seite auf, wobei von der ersten Seite des Schaltungsträgers wenigstens eine Kontaktleitung eingepresst ist.
Das Gehäuse weist erfindungsgemäß wenigstens ein Abstützelement auf. Das Abstützelement ist einem Bereich auf der zweiten Seite des Schaltungsträgers um die eingepresste Kontaktleitung zugeordnet.
Der Vorteil des erfindungsgemäßen Gehäuses besteht darin, dass durch das wenigstens eine Abstützelement ein Anschlag für den elektronischen Schaltungsträger gebildet wird, so dass beim Einpressvorgang eine Auslenkung und Verbiegung des Schaltungsträgers im Bereich der eingepressten Kontaktleitungen begrenzt wird. Die Abstützelemente, die beispielsweise stiftartig ausgebildet sind, kommen dazu, zumindest während des Einpressvorgangs, auf den zugeordneten Bereichen auf der zweiten Seite des Schaltungsträgers zu liegen. Die Einpresskräfte können dadurch durch das Gehäuse kompensiert werden, und eine Beschädigung des Schaltungsträgers bzw. der auf dem Schaltungsträger angeordneten Leiterbahnen und/oder elektronischen Bauteile wird vermieden.

Durch ein erfindungsgemäßes Gehäuse kann ein Einpressen der Kontaktleitungen unter Vermeidung einer Beschädigung des Schaltungsträgers auch bei einem weitgehend geschlossenen Gehäuse vorgenommen werden, da es nicht nötig ist, den Schaltungsträger im Bereich der eingepressten Kontaktleitungen durch ein separates Werkzeug abzustützen.

Das erfindungsgemäße Gehäuse kann also nachdem der Schaltungsträger darin montiert wurde bereits fertig verschlossen und gegebenenfalls transportiert werden. Wenn das Gehäuse beispielsweise ein elektronisches Steuergerät für den Einsatz in einem Kraftfahrzeug beinhaltet, so kann die Kontaktierung erst beim Einbau in das Kraftfahrzeug stattfinden, während die Fertigung des Gehäuses und die Montage des Schaltungsträgers in dem Gehäuse unabhängig von der Kontaktierung durchgeführt werden kann. Die elektrische Kontaktierung des Schaltungsträgers kann demnach räumlich und zeitlich versetzt vorgenommen werden, wodurch sich Produktions- und Montageabläufe vereinfachen lassen.

Nachdem der Einpressvorgang abgeschlossen ist, ist das wenigstens eine Abstützelement erfindungsgemäß durch einen Luftspalt von der Oberfläche des Schaltungsträgers getrennt. Ein Luftspalt zwischen Abstützelement und Schaltungsträger verhindert, dass im späteren Betrieb der Schaltung, beispielsweise durch die unterschiedlichen Wärmeausdehnungen von Abstützelement und Schaltungsträger, mechanische Spannungen entstehen. Der Luftspalt muss jedoch, abhängig von der Biegefähigkeit des Schaltungsträgers, so gewählt werden, dass beim Einpressvorgang immer noch eine Abstützung des Schaltungsträgers durch das Abstützelement erfolgt.

Zusätzlich können elastische Gegenelemente auf dem Schaltungsträger vorgesehen sein, auf denen die Abstützelemente aufliegen und durch deren elastische Eigenschaften mechanische Spannungen ausgeglichen werden können.

Die Abstützelemente sind bevorzugt in den Bereichen angeordnet, in denen während des Einpressvorgangs die größten Auslenkungen und Verbiegungen des Schaltungsträgers erwartet werden. Werden beispielsweise mehrere Kontaktleitungen simultan in benachbarte Kontaktöffnungen des Schaltungsträgers eingepresst, so ist es vorteilhaft, im Zwischenbereich zwischen den Kontaktöffnungen ein oder mehrere Abstützelemente vorzusehen.

Um eine möglichst gleichmäßige Aufnahme der Einpresskräfte durch die Abstützelemente zu erzielen, ist es vorteilhaft, mehrere Abstützelemente gleichmäßig um eine Kontaktöffnung für eine Kontaktleitung anzuordnen. Stiftartig ausgebildete Abstützelemente können dazu in gleichmäßigen Abständen um eine Kontaktöffnung angeordnet sein. Alternativ kann ein Abstützelement als Hohlkörper, beispielsweise als Hohlzylinder, ausgebildet sein, der eine Kontaktöffnung vollständig umgibt. Auch andere Ausgestaltungen der Abstützelemente, beispielsweise als Segmente eines Hohlzylinders, sind denkbar.

Das erfindungsgemäße Gehäuse kann zwei- oder mehrteilig, mit mindestens einem Boden- und Deckelteil, ausgebildet sein. Die Erfindung kann jedoch auch auf jede andere bekannte Bauweise eines Gehäuses zur Aufnahme eines elektronischen Schaltungsträgers angewendet werden, beispielsweise auf ein Einschubgehäuse. Beispielsweise bei Einschubgehäusen können die Kontaktleitungen sowie die Abstützelemente auch abgewinkelt ausgeführt werden.

Bevorzugt weist das Gehäuse in der Umgebung der Kontaktöffnungen des Schaltungsträgers wenigstens eine Durchführungsöffnung auf, durch die mindestens eine Kontaktleitung von außen zu der ersten Seite des Schaltungsträgers geführt werden kann. Die Durchführungsöffnung ist bevorzugt trichterförmig ausgebildet. Damit wird eine Ausrichtung der Kontaktleitungen auf die Kontaktöffnungen des Schaltungsträgers beim Durchführen bewirkt, so dass eine Verkantung der Kontaktleitung beim Einpressvorgang vermieden werden kann.

### Kurze Beschreibung der Zeichnungen

Figur 1 zeigt schematisch einen Schnitt durch ein Gehäuse nach einer ersten Ausführung der Erfindung.
Die Figuren 2 a) bis c) zeigen schematisch den Verlauf des Einpressvorgangs einer Kontaktleitung in einen Schaltungsträger in einem erfindungsgemäßen Gehäuse.
Figur 3 zeigt einen Ausschnitt aus einem Gehäuse nach einer zweiten Ausführung der Erfindung.
Die Figuren 4 a) bis c) zeigen jeweils eine Draufsicht auf einen Schaltungsträger mit eingepressten Kontaktleitungen und Auflagebereichen der Abstützelemente nach weiteren Ausführungen der Erfindung.

### Ausführungsformen der Erfindung

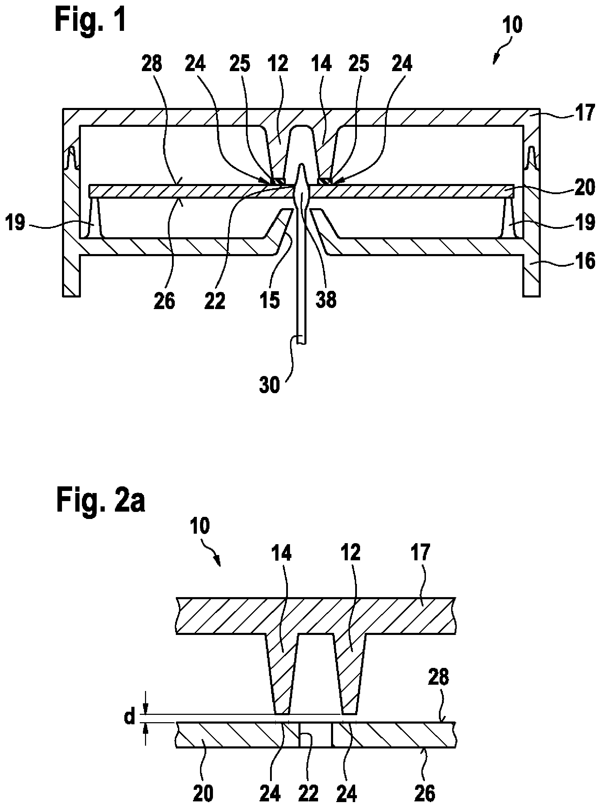

In Figur 1 ist ein Schnitt durch Gehäuse 10 nach einer ersten Ausführung der Erfindung dargestellt. Das Gehäuse 10 ist in diesem Beispiel zweiteilig aufgebaut und besteht aus Kunststoff. Alternativ kann das Gehäuse aus einem anderen geeigneten Material, beispielsweise Aluminium oder Stahl bestehen. Es weist ein wannenartig ausgeführtes Bodenteil 16 und ein Deckelteil 17 auf, wobei das Deckelteil 17 auf das Bodenteil 16 aufsetzbar ist. In dem Bodenteil 16 ist ein elektronischer Schaltungsträger angeordnet, der in diesem Beispiel als Leiterplatte 20 ausgebildet ist. Die Leiterplatte 20 kann beispielsweise aus faserverstärktem Kunststoff oder Keramik bestehen und weist nicht dargestellte Leiterbahnen und elektronische Bauelemente auf. Zur Halterung der Leiterplatte 20 weist das Bodenteil 16 Erhebungen 19 auf, auf denen die Leiterplatte 12 angeordnet ist und beispielsweise über Schrauben fixiert ist. Es sind auch andere Möglichkeiten der Halterung denkbar. Alternativ kann beispielsweise die Leiterplatte 20 über Einpressstifte oder seitliche Schienen an den Gehäusewänden gehalten werden.

Die Leiterplatte weist eine Kontaktöffnung 22 auf, über die die Leiterplatte 20 und die darauf angeordnete, nicht dargestellte, Schaltung von außen kontaktiert werden kann. Die Kontaktöffnung ist beispielsweise als metallisierte Bohrung ausgeführt. Alternativ kann auch eine metallische Hülse in eine Bohrung in der Leiterplatte 20 eingebracht werden, um die Kontaktöffnung 22 zu bilden.

Die Leiterplatte 20 weist eine erste Seite 26, die dem Bodenteil 16 des Gehäuses 10 zugewandt ist sowie eine gegenüberliegende, zweite Seite 28, die dem Deckelteil des Gehäuses zugewandt ist, auf. Das Bodenteil 16 weist eine Durchführungsöffnung 15 auf, durch die eine Kontaktleitung 30 ins Innere des Gehäuses 10 geführt ist. Die Durchführungsöffnung 15 liegt der Kontaktöffnung 22 auf der ersten Seite 26 der Leiterplatte 20 gegenüber. Die Durchführungsöffnung 15 hat einen trichterförmigen Querschnitt. Damit wird erreicht, dass die Kontaktleitung 30 bereits beim Durchführen durch die Durchführungsöffnung 15 auf die Position der Kontaktöffnung 22 ausgerichtet und zentriert wird, wodurch die Montage des Gehäuses erleichtert wird.

Erfindungsgemäß ist die Kontaktleitung 30 von der ersten Seite 26 der Leiterplatte 20 in die Kontaktöffnung 22 eingepresst, wodurch der elektrische Kontakt zwischen der Leiterplatte 20 und der Kontaktleitung 30 hergestellt ist. Die Kontaktleitung 30 verbindet die Schaltung auf der Leiterplatte 20 beispielsweise mit einem externen Verbraucher, einer externen Energiequelle oder einem Schalt- oder Regelelement. Das Ende der Kontaktleitung 30 ist in bekannter Weise als Einpresskontakt 38 ausgebildet: Es besitzt einen Durchmesser, der geringfügig größer ist als der Durchmesser der Kontaktöffnung 22. Beim Einpressen der Kontaktleitung 30 findet deshalb eine Verformung sowohl des Einpresskontakts 38 als auch der Kontaktöffnung 22 statt. Die damit aufgebaute Kraftwirkung im Bereich der Leiterplatte bewirkt, dass eine zuverlässige elektrische Verbindung zwischen der Kontaktöffnung 22 und dem Einpresskontakt 38 entsteht.

Da beim Einpressvorgang hohe Kräfte auf die Leiterplatte 20 einwirken, wird die Leiterplatte 20 während des Einpressvorgangs in Einpressrichtung ausgelenkt und verbiegt sich. Dies kann im ungünstigen Fall zur Beschädigung oder Zerstörung der leitenden Strukturen auf der Leiterplatte 20 in der Umgebung der Kontaktöffnung führen. Um dies zu vermeiden weist das Deckelteil 17 des Gehäuses, in diesem Beispiel zwei, Abstützelemente 12 und 14 auf. Der Zweck der Abstützelemente 12 und 14 ist es, einen Anschlag für die Leiterplatte 20 zu bilden. Die beim Einpressen der Kontaktleitung 30 in die Kontaktöffnung 22 wirkende Kraft auf die Leiterplatte 20 wird durch die Abstützelemente 12 und 14 erfindungsgemäß aufgenommen und von dem Deckelteil 17 des Gehäuses 10 kompensiert. Die Auslenkung der Leiterplatte 20 wird damit begrenzt und eine übermäßige Verbiegung während des Einpressens der Kontaktleitung 30 wird verhindert.

Die Abstützelemente 12 und 14 sind einteilig mit dem Deckelteil 17 ausgebildet. Sie erstrecken sich bis zur zweiten Seite 28 der Leiterplatte 20 und sind jeweils einem an die Kontaktöffnung 22 bzw. die eingepresste Kontaktleitung 30 angrenzenden Bereich 24 auf der zweiten Seite 28 der Leiterplatte 20 zugeordnet. Die Abstützelemente 12 und 14 sind in diesem Beispiel stiftförmig mit im Wesentlichen konischem Querschnitt ausgebildet. Sie liegen nach Abschluss des Einpressvorgangs entweder lose auf dem jeweiligen zugeordneten Bereich 24 der zweiten Seite 28 der Leiterplatte 20 auf oder sind durch einen schmalen Luftspalt von der Oberfläche der Leiterplatte 20 getrennt. Es ist vorteilhaft, wenn nach dem Einpressvorgang ein Luftspalt zwischen den Abstützelementen 12 und 14 und der zweiten Seite 28 der Leiterplatte 20 verbleibt. Würden die Abstützelemente 12 und 14 auch nach dem Einpressvorgang die zweite Seite 28 der Leiterplatte berühren, so könnten aufgrund der unterschiedlichen Wärmeausdehnungskoeffizienten des Leiterplattenmaterials und des Materials der Abstützelementen 12 und 14 zu ungewünschten mechanischen Spannungen und im schlimmsten Fall zu einer Beschädigung der Leiterplatte 20 kommen. Wenn, beispielsweise aufgrund von Fertigungstoleranzen, ein Luftspalt zwischen den Abstützelementen 12 und 14 und der zweiten Seite 28 der Leiterplatte 20 nicht garantiert werden kann, können auf der zweiten Seite 28 der Leiterplatte 20, in den Bereichen 24, in denen zumindest während des Einpressvorgangs eine Berührung zwischen der zweiten Seite 28 der Leiterplatte 20 und den Abstützelementen 12 und 14 stattfindet, Gegenelemente 25 angeordnet sein. Die Gegenelemente 25 weisen elastische Eigenschaften auf und können beispielsweise aus einem gummiartigen Material bestehen. Durch die elastischen Eigenschaften der Gegenelemente 25 können mechanische Spannungen, die aufgrund der unterschiedlichen Wärmeausdehnungskoeffizienten des Leiterplattenmaterials und des Materials der Abstützelementen 12 und 14 entstehen, ausgeglichen werden.

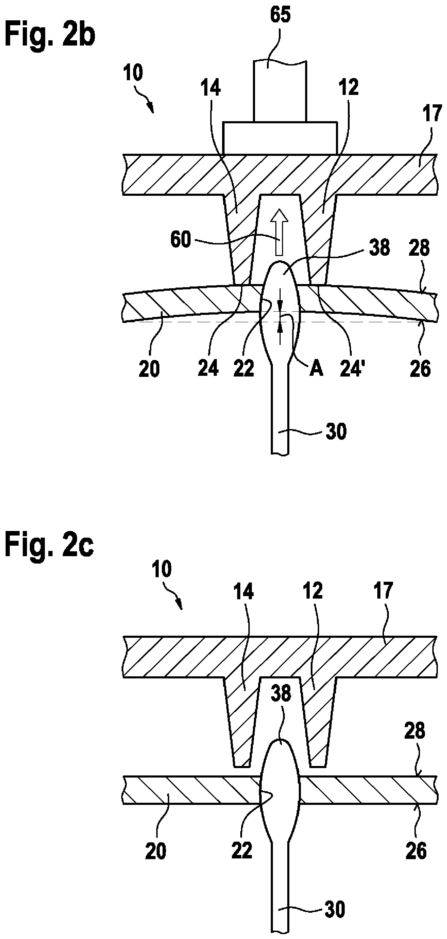

Der Vorgang des Einpressens wird durch die Figuren 2 a) bis c) illustriert. In Figur 2 a) ist ein Ausschnitt eines Gehäuses 10 mit einer darin angeordneten Leiterplatte 20 vor dem Einpressen einer Kontaktleitung dargestellt. Das Deckelteil 17 des Gehäuses weist zwei Abstützelemente 12 und 14 auf, die dem Bereich auf der zweiten Seite 28 des Schaltungsträgers 20 um eine Kontaktöffnung 22 zugeordnet sind. Zwischen der Oberfläche der Leiterplatte 20 und den Abstützelementen verbleibt in diesem Beispiel ein Luftspalt der Breite d. Da die maximale Auslenkung A der Leiterplatte im Wesentlichen proportional zur Einpresskraft und umgekehrt proportional zur Biegesteifigkeit der Leiterplatte 20 angenommen werden kann, ist die Breite d des Luftspaltes bevorzugt abhängig von diesen Größen ausgebildet. So ist es bei Materialien, die eine geringe Elastizität aufweisen, wie beispielsweise Keramiken, vorteilhaft, den Luftspalt klein im Vergleich zur Dicke des Schaltungsträgers zu wählen, da bereits geringe Verbiegungen zu Beschädigungen des Schaltungsträgers führen können.

Wie in Figur 2 b) dargestellt wird von der ersten Seite 26 der Leiterplatte 20 eine Kontaktleitung 30 mit einem als Einpresskontakt 38 ausgebildeten Ende eingepresst. Dabei wird eine Kraft in Einpressrichtung 60 auf die Leiterplatte 20 ausgeübt. In Folge wird die Leiterplatte ausgelenkt und verbiegt sich, bis die Abstützelemente auf der zweiten Seite 28 der Leiterplatte 20 in den Bereichen 24 anliegen und einen Anschlag für die Leiterplatte 20 bilden. Durch die Abstützelemente 12 und 14 wird die Auslenkung A der Leiterplatte im Bereich der eingepressten Kontaktleitung begrenzt. Die auf die Leiterplatte 20 wirkende Kraft wird über die Abstützelemente 12 und 14 aufgenommen und vom Gehäuse 10 kompensiert. Die Abstützelemente 12 und 14 üben eine Gegenkraft auf die Leiterplatte 20 aus. Eine Beschädigung der Leiterplatte durch eine übermäßige Verbiegung wird dadurch vermieden.

Um eine zusätzliche Abstützwirkung zu erzielen, kann während des Einpressens der Deckel 17 des Gehäuses 10 zusätzlich durch ein Werkzeug 65 von außen abgestützt werden.

Wie in Figur 2 c) dargestellt, kehrt die Leiterplatte 20 nach dem Einpressvorgang weitestgehend in ihre Ausgangslage zurück und zwischen der zweiten Seite 28 der Leiterplatte 20 und den Abstützelementen 12 und 14 ist wieder ein Luftspalt angeordnet.

Die Abstützelemente 12 und 14 können einteilig mit dem Gehäuse 10 ausgebildet sein, es ist jedoch auch denkbar, Abstützelemente vor dem Einpressvorgang in das Gehäuse 10 einzubringen und nach dem Einpressvorgang wieder zu entfernen. Dazu können beispielsweise Öffnungen im Gehäuse vorgesehen sein.

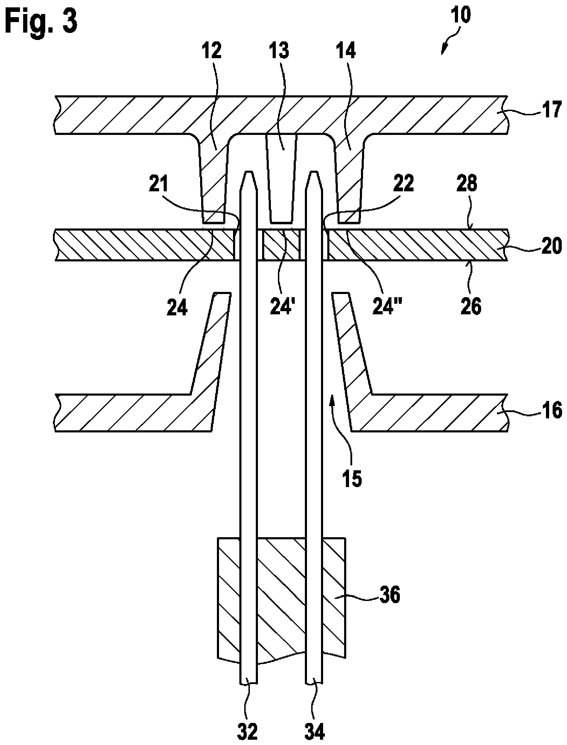

In Figur 3 ist ein Ausschnitt eines Gehäuses 10 nach einer alternativen Ausführung der Erfindung dargestellt. Der Aufbau entspricht im Wesentlichen dem in Figur 1 dargestellten Gehäuse. Gleiche Elemente sind mit den gleichen Bezugszeichen versehen.

In dieser Ausführung der Erfindung weist der elektronische Schaltungsträger, der wiederum als Leiterplatte 20 ausgeführt ist, zwei benachbart angeordnete Kontaktöffnungen 21 und 22 auf. Zwei Kontaktleitungen 32 und 34 sind durch eine gemeinsame, trichterförmig ausgebildete Durchführungsöffnung 15 des Gehäusebodenteils 16 geführt und von der ersten Seite 26 der Leiterplatte 20 jeweils in eine Kontaktöffnung 21 bzw. 22 eingepresst. Außerhalb des Gehäuses 10 sind die Kontaktleitungen 32 und 34 von einer gemeinsamen, elektrisch isolierenden Hülle 36 umgeben.

Das Deckelteil 17 des Gehäuses 10 weist erfindungsgemäß Abstützelemente 12, 13 und 14 auf. Diese sind so angeordnet, dass ein Abstützelement 13 dem Bereich 24' zwischen den beiden Kontaktöffnungen 21 und 22 auf der zweiten Seite 28 der Leiterplatte 20 zugeordnet ist. Ein weiteres Abstützelement 12 ist einem Bereich 24 auf der zweiten Seite 28 der Leiterplatte 20 neben der Kontaktöffnung 21 zugeordnet. Ein drittes Abstützelement 14 ist einem Bereich 24" auf der zweiten Seite 28 der Leiterplatte 20 neben der Kontaktöffnung 22 zugeordnet. Die Abstützelemente 12, 13 und 14 sind stiftartig ausgebildet und weisen beispielsweise einen im Wesentlichen konischen Querschnitt auf. In diesem Beispiel sind die Abstützelemente 12, 13 und 14 so angeordnet, dass die Bereiche 24, 24' und 24" und die Kontaktöffnungen 21 und 22 in einer Schnittebene liegen. Alternativ kann das Abstützelement 13 auch versetzt zu den Abstützelementen 12 und 14 angeordnet sein.

Beim Einpressen der Kontaktleitungen 32 und 34 in die Kontaktöffnungen 21 und 22 tritt eine Auslenkung und Verbiegung der Leiterplatte 20 auf. Das Abstützelement 13 bildet in dem Bereich 24' zwischen den Kontaktöffnungen 21 und 22 einen Anschlag für die Leiterplatte 20 während des Einpressvorgangs aus. Die Abstützelemente 12 und 14 und bilden jeweils einen Anschlag für die Leiterplatte 20 in den Bereichen 24 und 24" seitlich der Kontaktöffnungen 21 und 22 aus. Über die Abstützelemente 12, 13 und 14 werden die während des Einpressvorgangs einwirkenden Kräfte von dem Gehäuse 10 kompensiert und eine übermäßige Verbiegung der Leiterplatte 20 verhindert. Wenn beide Kontaktleitungen 32 und 34 simultan in die Kontaktöffnungen 21 und 22 eingepresst werden, ist die Krafteinwirkung auf die Leiterplatte 20 im Bereich 24' zwischen den Kontaktöffnungen 21 und 22 besonders groß, da sich die Einpresskräfte von beiden Kontaktleitungen überlagern. Deshalb kann das Abstützelement 13 beispielsweise eine größere Dicke aufweisen, als die beiden Abstützelemente 12 und 14.

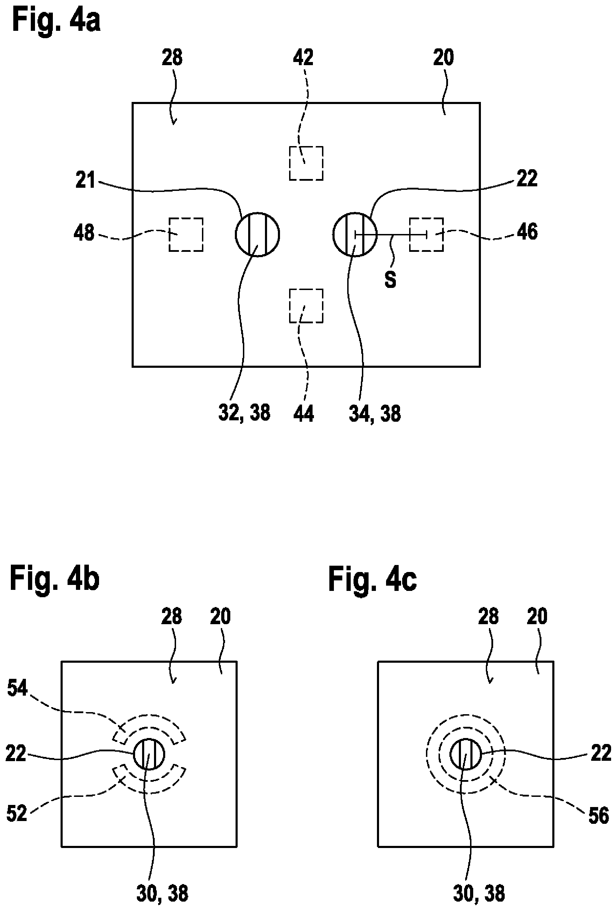

Bei großen Einpresskräften kann es vorteilhaft sein, vor allem zwischen zwei Kontaktöffnungen 21 und 22, mehrere Abstützelemente vorzusehen oder die Form der Abstützelemente zu variieren, um die Kräfte während des Einpressvorgangs optimal aufnehmen. In Figur 4 a) ist ein Ausschnitt eines Schaltungsträgers 20 in Draufsicht auf seine zweite Seite 28 dargestellt. In dem dargestellten Ausschnitt sind zwei Kontaktöffnungen 21 und 22 angeordnet in die jeweils eine Kontaktleitung 32 und 34 eingepresst ist. In der Umgebung der Kontaktöffnungen 21 und 22 sind vier Abstützelemente 42, 44, 46 und 48 angeordnet. Zumindest während des Einpressvorgangs liegt wenigstens eines der Abstützelemente 42, 44, 46 und 48 auf der zweiten Seite 28 der Leiterplatte 20 auf und bildet einen Anschlag für die Leiterplatte 20 aus.

Die Abstützelemente 42, 44, 46 und 48 sind symmetrisch mit jeweils im Wesentlichen gleichen Abständen s um die Kontaktöffnungen 21 und 22 angeordnet. Im Bereich zwischen den beiden Kontaktöffnungen 21 und 22, in dem beim simultanen Einpressen der Kontaktleitungen 32 und 34 die größten Kräfte erwartet werden sind zwei Abstützelemente 42 und 44 angeordnet. Durch diese symmetrische Anordnung der Abstützelemente 42, 44, 46 und 48 wird eine gleichmäßige Aufnahme der Einpresskräfte während des Einpressvorgangs der Kontaktleitungen in die Kontaktöffnungen 21 und 22 der Leiterplatte 20 gewährleistet.

In den Figuren 4 b) und 4c) ist jeweils ein Ausschnitt eines Schaltungsträgers 20 in Draufsicht auf die zweite Seite 28 dargestellt. In dem dargestellten Ausschnitt ist eine Kontaktöffnung 22 angeordnet in eine Kontaktleitung 30 eingepresst ist. In Figur 4 b) sind um die eingepresste Kontaktleitung zwei Abstützelemente 52 und 54 angeordnet, die zumindest während des Einpressvorgangs auf der zweiten Seite 28 der Leiterplatte 20 aufliegen und einen Anschlag für die Leiterplatte 20 ausbilden. Die Abstützelemente sind als Segmente eines Hohlzylinders ausgebildet. Alternativ kann ein einziges, als vollständiger Hohlzylinder ausgeführtes Abstützelement 56 vorgesehen sein, wie in Figur 4 c) dargestellt ist. Durch die flächige Ausbildung der Auflagebereiche der Abstützelemente 52 und 54 bzw. 56 wird eine besonders gleichmäßige Kraftaufnahme erzielt.

## Patentansprüche

1. Gehäuse (10) zur Aufnahme eines elektronischen Schaltungsträgers (20), wobei
- der Schaltungsträger (20) eine erste (26) und eine gegenüberliegende zweite Seite (28) aufweist und
- der Schaltungsträger (20) von der ersten Seite (26) aus wenigstens eine eingepresste Kontaktleitung (30, 32, 34) aufweist, wobei
- das Gehäuse (10) wenigstens ein Abstützelement (12, 13, 14, 42, 44, 46, 48, 52, 54, 56) aufweist, wobei
- das mindestens ein Abstützelement (12, 13, 14, 42, 44, 46, 48, 52, 54, 56) einem Bereich (24, 24', 24") auf der zweiten Seite (28) des Schaltungsträgers (20) um die eingepresste Kontaktleitung (30, 32, 34) zugeordnet ist, so dass beim Einpressvorgang der Kontaktleitung eine Auslenkung und Verbiegung des Schaltungsträgers begrenzt wird,
**dadurch gekennzeichnet, dass**
zwischen dem Schaltungsträger (20) und dem wenigstens einem Abstützelement (12, 13, 14, 42, 44, 46, 48, 52, 54, 56) ein Luftspalt angeordnet ist, wobei die Breite (d) des Luftspalts abhängig von der Biegefähigkeit des Schaltungsträgers (20) so gewählt ist, dass beim Einpressvorgang immer noch eine Abstützung des Schaltungsträgers (20) durch das Abstützelement (12, 13, 14, 42, 44, 46, 48, 52, 54, 56) erfolgt.

2. Gehäuse (10) nach Anspruch 1, **dadurch gekennzeichnet, dass** das wenigstens eine Abstützelement (12, 13, 14, 42, 44, 46, 48, 52, 54, 56) an der zweiten Seite (28) des Schaltungsträgers (20) auf dem Schaltungsträger (20) aufliegt.

3. Gehäuse (10) nach einem der Ansprüche 1 oder 2, **dadurch gekennzeichnet, dass** in einem Bereich (24, 24', 24") auf der zweiten Seite (28) des Schaltungsträgers (20), der einem Abstützelement (12, 13, 14, 42, 44, 46, 48, 52, 54, 56) zugeordnet ist, mindestens ein elastisch ausgebildetes Gegenelement (25) angeordnet ist.

4. Gehäuse (10) nach einem der Ansprüche 1 bis 3, **dadurch gekennzeichnet, dass** der Schaltungsträger (20) mehrere eingepresste Kontaktleitungen (32, 34) aufweist und jeweils mindestens ein Abstützelement (13, 42, 44) einem Bereich (24') zwischen zwei eingepressten Kontaktleitungen (32, 34) zugeordnet ist.

5. Gehäuse (10) nach einem der Ansprüche 1 bis 4, **dadurch gekennzeichnet, dass** Abstützelemente (42, 44, 46, 48) mindestens zwei Bereichen in der Umgebung einer eingepressten Kontaktleitung (32, 34) zugeordnet sind, wobei die Bereiche insbesondere jeweils gleiche Abstände (s) zu der eingepressten Kontaktleitung (32, 34) und jeweils gleiche Abstände zueinander aufweisen.

6. Gehäuse (10) nach einem der Ansprüche 1 bis 5, **dadurch gekennzeichnet, dass** das Gehäuse (10) ein Bodenteil (16) und ein Deckelteil (17) aufweist, wobei wenigstens ein Abstützelement (12, 13, 14) im Deckelteil (17) des Gehäuses (10) ausgebildet ist.

7. Gehäuse (10) nach einem der Ansprüche 1 bis 6, **dadurch gekennzeichnet, dass** mindestens ein Abstützelement (12, 13, 14) als Stift, insbesondere mit konischem Querschnitt, ausgebildet ist.

8. Gehäuse (10) nach einem der Ansprüche 1 bis 7, **dadurch gekennzeichnet, dass** mindestens ein Abstützelement als Hohlzylinder oder Teilsegment eines Hohlzylinders ausgebildet ist.

9. Gehäuse (10) nach einem der Ansprüche 1 bis 8, **dadurch gekennzeichnet, dass** mindestens ein Abstützelement (12, 13, 14) einteilig mit dem Gehäuse (10), insbesondere mit dem Deckelteil (17) des Gehäuses, ausgebildet ist.

10. Gehäuse (10) nach einem der Ansprüche 1 bis 9, **dadurch gekennzeichnet, dass** das Gehäuse (10) im Bereich der eingepressten Kontaktleitungen (30, 32, 34) wenigstens eine Durchführungsöffnung (15) zur Durchführung einer Kontaktleitung (30, 32, 34) aufweist, wobei die Durchführungsöffnung (15) trichterförmig ausgebildet ist und damit eine Zentrierung der durch die Durchführungsöffnung (15) geführten Kontaktleitungen (30, 32, 34) bewirkt.

11. Verfahren zur Montage und Kontaktierung eines Gehäuses (10) zur Aufnahme eines elektronisches Schaltungsträgers (20) nach einem der Ansprüche 1 bis 10, das die folgenden Verfahrensschritte aufweist:
- Einbringen eines Schaltungsträgers (20) in das Gehäuse,
- Führen von mindestens einer Kontaktleitung (30, 32, 34), insbesondere durch eine Durchführungsöffnung (15) des Gehäuses (10), zu einer ersten Seite (26) des Schaltungsträgers (20),
- Einpressen der Enden (38) der Kontaktleitungen (30, 32, 34) in entsprechende Kontaktöffnungen (21, 22) des Schaltungsträgers, wobei
- der Schaltungsträger (20) im Bereich der Kontaktöffnungen (21, 22) eine Auslenkung (A) in Einpressrichtung (60) erfährt,
- wodurch der Schaltungsträger (20) mit einer zweiten Seite (28) wenigstens ein Abstützelement (12, 13, 14, 42, 44, 46, 48, 52, 54, 56) des Gehäuses (10) in mindestens einem Bereich (24, 24', 24") auf der zweiten Seite (28) des Schaltungsträgers (20) berührt und das Abstützelement (12, 13, 14) einen Anschlag für den Schaltungsträger (20) bildet.

12. Verfahren nach Anspruch 11 **dadurch gekennzeichnet, dass** wenigstens ein Abstützelement (12, 13, 14) nach dem Einpressen der Kontaktleitungen (30, 32, 34) aus dem Gehäuse (10) entfernt wird.

## Claims

1. Housing (10) for accommodating an electronic circuit carrier (20), wherein
- the circuit carrier (20) has a first side (26) and an opposite second side (28) and
- the circuit carrier (20) has at least one contact line (30, 32, 34) which is pressed in from the first side (26), wherein
- the housing (10) has at least one supporting element (12, 13, 14, 42, 44, 46, 48, 52, 54, 56), wherein
- the at least one supporting element (12, 13, 14, 42, 44, 46, 48, 52, 54, 56) is associated with a region (24, 24', 24'') on the second side (28) of the circuit carrier (20) around the pressed-in contact line (30, 32, 34), so that, during the process of pressing-in the contact line, deflection and warping of the circuit carrier is limited,
**characterized in that**
an air gap is arranged between the circuit carrier (20) and the at least one supporting element (12, 13, 14, 42, 44, 46, 48, 52, 54, 56), wherein the width (d) of the air gap is selected, depending on the flexibility of the circuit carrier (20), such that the supporting element (12, 13, 14, 42, 44, 46, 48, 52, 54, 56) still supports the circuit carrier (20) during the pressing-in process.

2. Housing (10) according to Claim 1, **characterized in that** the at least one supporting element (12, 13, 14, 42, 44, 46, 48, 52, 54, 56) rests on the circuit carrier (20) on the second side (28) of the circuit carrier (20).

3. Housing (10) according to either of Claims 1 and 2, **characterized in that** at least one elastic mating element (25) is arranged in a region (24, 24', 24'') on the second side (28) of the circuit carrier (20), which region is associated with a supporting element (12, 13, 14, 42, 44, 46, 48, 52, 54, 56).

4. Housing (10) according to one of Claims 1 to 3, **characterized in that** the circuit carrier (20) has a plurality of pressed-in contact lines (32, 34) and in each case at least one supporting element (13, 42, 44) is associated with a region (24') between two pressed-in contact lines (32, 34).

5. Housing (10) according to one of Claims 1 to 4, **characterized in that** supporting elements (42, 44, 46, 48) are associated with at least two regions in the area surrounding a pressed-in contact line (32, 34), wherein the regions are in particular in each case at identical distances (s) from the pressed-in contact line (32, 34) and in each case at identical distances from one another.

6. Housing (10) according to one of Claims 1 to 5, **characterized in that** the housing (10) has a base part (16) and a cover part (17), wherein at least one supporting element (12, 13, 14) is formed in the cover part (17) of the housing (10).

7. Housing (10) according to one of Claims 1 to 6, **characterized in that** at least one supporting element (12, 13, 14) is designed as a pin, in particular with a conical cross section.

8. Housing (10) according to one of Claims 1 to 7, **characterized in that** at least one supporting element is designed as a hollow cylinder or partial segment of a hollow cylinder.

9. Housing (10) according to one of Claims 1 to 8, **characterized in that** at least one supporting element (12, 13, 14) is integrally formed with the housing (10), in particular with the cover part (17) of the housing.

10. Housing (10) according to one of Claims 1 to 9, **characterized in that** the housing (10) has at least one leadthrough opening (15) for leading-through a contact line (30, 32, 34) in the region of the pressed-in contact lines (30, 32, 34), wherein the leadthrough opening (15) is of funnel-like design and therefore centres the contact lines (30, 32, 34) which are guided through the leadthrough opening (15).

11. Method for assembling and making contact with a housing (10) for accommodating an electronic circuit carrier (20) according to one of Claims 1 to 10, which method comprises the following method steps:
- inserting a circuit carrier (20) into the housing,
- guiding at least one contact line (30, 32, 34), in particular through a leadthrough opening (15) of the housing (10), to a first side (26) of the circuit carrier (20),
- pressing the ends (38) of the contact lines (30, 32, 34) into corresponding contact openings (21, 22) of the circuit carrier, wherein
- the circuit carrier (20) undergoes a deflection (A) in the press-in direction (60) in the region of the contact openings (21, 22),
- as a result of which the circuit carrier (20), by way of a second side (28), makes contact with at least one supporting element (12, 13, 14, 42, 44, 46, 48, 52, 54, 56) of the housing (10) in at least one region (24, 24', 24'') on the second side (28) of the circuit carrier (20), and the supporting element (12, 13, 14) forms a stop for the circuit carrier (20).

12. Method according to Claim 11, **characterized in that** at least one supporting element (12, 13, 14) is removed from the housing (10) after the contact lines (30, 32, 34) are pressed in.

## Revendications

1. Boîtier (10) destiné à accueillir un porte-circuit (20) électronique,
- le porte-circuit (20) possédant un premier côté (26) et un deuxième côté (28) opposé et
- le porte-circuit (20) possédant au moins une ligne de contact (30, 32, 34) enfoncée depuis le premier côté (26),
- le boîtier (10) possédant au moins un élément de soutien (12, 13, 14, 42, 44, 46, 48, 52, 54, 56),
- l'au moins un élément de soutien (12, 13, 14, 42, 44, 46, 48, 52, 54, 56) étant associé à une zone (24, 24', 24'') sur le deuxième côté (28) du porte-circuit (20) autour de la ligne de contact (30, 32, 34) enfoncée, de sorte que lors de l'opération d'enfoncement de la ligne de contact, une déviation et une déformation du porte-circuit sont limitées,
**caractérisé en ce que**
un intervalle d'air est disposé entre le porte-circuit (20) et l'au moins un élément de soutien (12, 13, 14, 42, 44, 46, 48, 52, 54, 56), la largeur (d) de l'intervalle d'air étant choisie en fonction de la flexibilité du porte-circuit (20) de telle sorte que lors de l'opération d'enfoncement, un soutien du porte-circuit (20) par l'élément de soutien (12, 13, 14, 42, 44, 46, 48, 52, 54, 56) a toujours encore lieu.

2. Boîtier (10) selon la revendication 1, **caractérisé en ce que** l'au moins un élément de soutien (12, 13, 14, 42, 44, 46, 48, 52, 54, 56) repose sur le porte-circuit (20) contre le deuxième côté (28) du porte-circuit (20).

3. Boîtier (10) selon l'une des revendications 1 ou 2, **caractérisé en ce qu'**au moins un élément homologue (1) de configuration élastique est disposé dans une zone (24, 24', 24'') sur le deuxième côté (28) du porte-circuit (20) à laquelle est associé un élément de soutien (12, 13, 14, 42, 44, 46, 48, 52, 54, 56).

4. Boîtier (10) selon l'une des revendications 1 à 3, **caractérisé en ce que** le porte-circuit (20) possède plusieurs lignes de contact (32, 34) enfoncées et au moins un élément de soutien (13, 42, 44) est respectivement associé à une zone (24') entre deux lignes de contact (32, 34) enfoncées.

5. Boîtier (10) selon l'une des revendications 1 à 4, **caractérisé en ce que** des éléments de soutien (42, 44, 46, 48) sont associés à au moins deux zones dans l'environnement d'une ligne de contact (32, 34) enfoncée, les zones possédant notamment respectivement des écarts (s) identiques par rapport à la ligne de contact (32, 34) enfoncée et respectivement des écarts identiques les unes des autres.

6. Boîtier (10) selon l'une des revendications 1 à 5, **caractérisé en ce que** le boîtier (10) possède une partie de fond (16) et une partie de couvercle (17), au moins un élément de soutien (12, 13, 14) étant formé dans la partie de couvercle (17) du boîtier (10).

7. Boîtier (10) selon l'une des revendications 1 à 6, **caractérisé en ce qu'**au moins un élément de soutien (12, 13, 14) est réalisé sous la forme d'une broche, ayant notamment une section transversale conique.

8. Boîtier (10) selon l'une des revendications 1 à 7, **caractérisé en ce qu'**au moins un élément de soutien est réalisé sous la forme d'un cylindre creux ou d'un segment partiel d'un cylindre creux.

9. Boîtier (10) selon l'une des revendications 1 à 8, **caractérisé en ce qu'**au moins un élément de soutien (12, 13, 14) est réalisé d'un seul tenant avec le boîtier (10), notamment avec la partie de couvercle (17) du boîtier (10).

10. Boîtier (10) selon l'une des revendications 1 à 9, **caractérisé en ce que** le boîtier (10) possède dans la zone des lignes de contact (30, 32, 34) enfoncées au moins une ouverture de traversée (15) destinée à la traversée d'une ligne de contact (30, 32, 34), l'ouverture de traversée (15) étant réalisée en forme d'entonnoir et produisant ainsi un centrage des lignes de contact (30, 32, 34) guidées à travers l'ouverture de traversée (15).

11. Procédé de montage et de mise en contact d'un boîtier (10) destiné à accueillir un porte-circuit (20) électronique selon l'une des revendications 1 à 10, lequel comprend les étapes suivantes :
- introduction d'un porte-circuit (20) dans le boîtier,
- guidage d'au moins une ligne de contact (30, 32, 34), notamment à travers une ouverture de traversée (15) du boîtier (10), jusqu'à un premier côté (26) du porte-circuit (20),
- enfoncement des extrémités (38) des lignes de contact (30, 32, 34) dans des ouvertures de contact (21, 22) correspondantes du porte-circuit (20),
- le porte-circuit (20) subissant, dans la zone des ouvertures de contact (21, 22), une déviation (A) dans la direction de l'enfoncement (60),
- moyennant quoi le porte-circuit (20) vient toucher par un deuxième côté (28) au moins un élément de soutien (12, 13, 14, 42, 44, 46, 48, 52, 54, 56) du boîtier (10) dans au moins une zone (24, 24', 124'') sur le deuxième côté (28) du porte-circuit (20) et l'élément de soutien (12, 13, 14) forme une butée pour le porte-circuit (20).

12. Procédé selon la revendication 11, **caractérisé en ce que** l'au moins un élément de soutien (12, 13, 14) est retiré hors du boîtier (10) après l'enfoncement des lignes de contact (30, 32, 34).
